# EUROPEAN PATENT APPLICATION

(11) **EP 1 239 294 A2**
(43) Date of publication of application: **11.09.2002**
(21) Application number: 02003268.6
(22) Date of filing: 21.02.2002
(51) Int. Cl.: G01R 33/038

(54) **Scanning magnetism detector and probe for the same**

(30) Priority: 05.03.2001 JP 2001059440
(71) Applicant: HOKKAIDO UNIVERSITY, Sapporo City Hokkaido (JP)
(72) Inventor: Mukasa, Koichi, Sapporo City, Hokkaido (JP); Sawamura, Makoto, Sapporo City, Hokkaido (JP); Sueoka, Kazuhisa, Sapporo City, Hokkaido (JP); Hirota, Eiichi, Hirakata City, Osaka (JP)
(74) Representative: von Hellfeld, Axel, Dr. Dipl.-Phys.

(57) **Abstract**

A scanning magnetism detector includes a probe made of a solid material of single crystal having spin polarization and electrical conductivity. The probe is approached to a given magnetic substance and the surface condition of the magnetic substance is detected by measuring the tunnel current between the probe and the surface of the magnetic substance.

## Description

### Background of the Invention

### Field of the Invention

This invention relates to a scanning magnetism detector and a probe for the scanning magnetism detector, particularly usable for a tunnel electron microscope.

### Description of the prior art

Conventionally, such a scanning magnetism detector as having a probe made of ferromagnetic metal or single crystal of chromium dioxide is employed in order to investigate, in atomic scale, the surface condition of a given magnetic substance through the tunnel current.

In the scanning magnetism detector having the probe of ferromagnetic metal, however, the probe may magnetically interact with the magnetic substance strongly, and thus, the magnetic condition of the magnetic substance may be disordered. Therefore, it is difficult to investigate the surface condition of the magnetic substance precisely.

On the other hand, in the scanning magnetism detector having the probe of the chromium dioxide single crystal, the magnetic condition (spin condition) of the forefront of the probe is not cleared, and the forefront of the probe may be contaminated due to the physical property of the oxide.

In this point of view, a scanning magnetism detector having a prove made of III-V semiconductor compound is proposed. In the scanning magnetism detector, the tunnel current of the spin-polarized conduction electrons of the III-V semiconductor compound due to the photoexcitation is used. Since the III-V semiconductor compound is non-magnetic, the above-mentioned magnetic disorder does not occur, but the total system of the scanning magnetism detector is made large and complicated because a given laser system or the like is required.

### Summery of the Invention

It is an object of the present invention, in this point of view, to provide a new scanning magnetism detector and a probe for the scanning magnetism detector.

For achieving the above object, this invention relates to a scanning magnetism detector comprising a probe made of a solid material of single crystal having spin polarization and electrical conductivity, whereby said probe is approached to a given magnetic substance and the surface condition of said magnetic substance is detected by measuring the tunnel current between said probe and the surface of said magnetic substance.

This invention also relate to a probe for a scanning magnetism detector made of a solid material of single crystal having electrical conductivity and spin polarization, to be approached to a given magnetic substance, whereby the surface condition of said magnetic substance is detected by measuring the tunnel current between said probe and said magnetic substance.

The inventors had intensely studied to attain the above object, and thus, found out a new scanning magnetism detector and a probe for the detector as mentioned above.

When the probe of the scanning magnetism detector of the present invention is approached to the surface of a given magnetic substance, the wave function of the electrons atom in the forefront of the probe is overlapped with the S-type wave function of the electrons atom in the surface of the magnetic substance. In this case, the probe is magnetically saturated by the exchange interaction from the magnetic field of the magnetic substance, and thus, a given tunnel current is flown between the probe and the magnetic substance. The amount and the direction of the tunnel current depends on the magnitude and the direction of the magnetic momentum in the surface of the magnetic substance.

That is, as the magnitude of the magnetic momentum in the surface of the magnetic substance becomes larger, the amount of the tunnel current becomes larger. Also, the tunnel current is flown parallel to the direction of the magnetic momentum.

On the other hand, if the sort and the arrangement of the atoms constructing the surface of the magnetic substance are changed, the magnetic momentum is also changed. Therefore, the amount and the direction of the thus detected tunnel current depends on the sort and the arrangement of the atoms constituting the surface of the magnetic substance, and thus, the surface condition of the magnetic substance can be detected by the amount and the direction of the tunnel current.

### Description of the Preferred Embodiments

This invention will be described in detail with reference to the accompanying drawings. It is required in the present invention that the probe of the scanning magnetism detector is made of a single crystalline solid material having electrical conductivity and spin polarization. Two types of the solid material can be exemplified: one is that the solid material itself has electrical conductivity and spin polarization, and the other is that the solid material is non-electrical conductivity and has only spin polarization, and thus, donor elements are added into the solid material.

As the former type solid material, are exemplified CuF, CuCl, AgI, ZnS, ZnSe, CdS, CdSe, BP, AlAs, AlP, AlSb, GaN, GaP, GaAs, GaSb, InAs, InP, InSb and SiC, which have zinc-blende crystal structure. Also, as the former type solid material, are exemplified Si, Ge and Sn which have diamond crystal structure.

As the latter type solid material is exemplified BN which has zinc-blende crystal structure. Also, as the latter type solid material is exemplified C which has diamond crystal structure.

Since such a solid material as having zinc-blende crystal structure or diamond crystal structure has an imperfect non-bonding orbit therein, the above mentioned solid material can have spin polarization in good condition.

As a donor element for the solid material of non-electrical conductivity, B as a III element in periodic table and P or As as a V element in periodic table are exemplified. These elements are partially replaced for the atoms at the crystal lattice sites of the solid material, and thus, functions as electron supply sources. As a result, the solid material can have electrical conductivity.

The configuration of the probe is not restricted, but is preferably formed in pyramid shape, particularly if the solid material is made of a material of zinc-blende crystal structure or diamond crystal structure as mentioned above.

The forefront of the pyramid shaped probe is constructed of the crossed crystal faces of the solid material of zinc-blende crystal structure or diamond crystal structure. The pyramid shaped probe is symmetric for the axis through the vertex thereof. Then, since the pyramid shaped prove is made of the solid material of non-magnetic as mentioned above, the magnetic momentum of the probe is generated around the symmetric axis. Therefore, the surface condition of the magnetic substance can be detected precisely by the pyramid shaped probe without the affection for the magnetic condition of the magnetic substance.

The dimension of the probe depends on the sort of information to be detected from the surface of the magnetic substance. For detecting the surface condition of the magnetic substance in atomic scale, and thus, providing a practical probe and a practical scanning magnetism detector, the dimension of the probe is preferably set to 100 nm or below, particularly 10 nm or below.

Herein, the term "the dimension of the probe" means the size of each component to define the configuration of the probe. In the case of the pyramid shaped probe, the term "the dimension of the probe" means the height and the bottom length of the probe.

It is desired that the probe is made by cleaving a bulky solid material as mentioned above. In this case, such a pyramid shaped probe can be easily made within a designed dimension.

Moreover, the probe may be made through crystal growth by a CVD method or a MOCVD method.

The scanning magnetism detector may be employed as a scanning magnetic force microscope or a scanning tunnel electron microscope in view of the configuration and the detecting principle. Particularly, only by replacing the probe of a conventional scanning tunnel electron microprobe with the probe of the present invention, as mentioned above, a scanning tunnel electron microscope can be composed of the scanning magnetism detector of the present invention.

Although the present invention was described in detail with reference to the above examples, this invention is not limited to the above disclosure and every kind of variation and modification may be made without departing from the scope of the present invention.

As mentioned above, according to the present invention, a scanning magnetism detector includes a probe made of a single crystalline solid material having spin polarization. Then, the tunnel current between the probe and a given magnetic substance is measured. Since the amount and the direction of the tunnel current depends on the surface condition of the magnetic substance, the surface condition can be detected precisely by measuring the tunnel current.

## Claims

1. A scanning magnetism detector comprising a probe made of a solid material of single crystal having spin polarization and electrical conductivity, whereby said probe is approached to a given magnetic substance and the surface condition of said magnetic substance is detected by measuring the tunnel current between said probe and the surface of said magnetic substance.

2. A scanning magnetism detector as defined in claim 1, wherein said solid material is a single crystalline material having zinc-blende crystal structure.

3. A scanning magnetism detector as defined in claim 2, wherein said solid material is at least one material selected from the group consisting of CuF, CuCl, AgI, ZnS, ZnSe, CdS, CdSe, BP, AlAs, AlP, AlSb, GaN, GaP, GaAs, GaSb, InAs, InP, InSb and SiC.

4. A scanning magnetism detector as defined in claim 2, wherein said solid material is a BN single crystal of which the crystal lattice sites are partially replaced by donor elements.

5. A scanning magnetism detector as defined in claim 1, wherein said solid material is a single crystalline material having diamond crystal structure.

6. A scanning magnetism detector as defined in claim 5, wherein said solid material is at least one material selected from the group consisting of Si, Ge and Sn.

7. A scanning magnetism detector as defined in claim 5, wherein said solid material is a carbon single crystal of which the crystal lattice sites are partially replaced by donor elements.

8. A scanning magnetism detector as defined in any one of claims 2-7, wherein said probe is formed in pyramid shape.

9. A scanning magnetism detector as defined in any one of claims 1-8, wherein the dimension of said probe is set to 10 nm or below.

10. A scanning magnetism detector as defined in any one of claims 1-9, wherein said probe is made by cleaving a given bulky single crystal.

11. A scanning tunnel electron microprobe comprising a scanning magnetism detector as defined in any one of claims 1-10.

12. A probe for a scanning magnetism detector made of a solid material of single crystal having electrical conductivity and spin polarization, to be approached to a given magnetic substance, whereby the surface condition of said magnetic substance is detected by measuring the tunnel current between said probe and said magnetic substance.

13. A probe as defined in claim 12, wherein said solid material is a single crystalline material having zinc-blende crystal structure.

14. A probe as defined in claim 13, wherein said solid material is at least one material selected from the group consisting of CuF, CuCl, AgI, ZnS, ZnSe, CdS, CdSe, BP, AlAs, AlP, AlSb, GaN, GaP, GaAs, GaSb, InAs, InP, InSb and SiC.

15. A probe as defined in claim 13, wherein said solid material is a BN single crystal of which the crystal lattice sites are partially replaced by donor elements.

16. A probe as defined in claim 12, wherein said solid material is a single crystalline material having diamond crystal structure.

17. A probe as defined in claim 16, wherein said solid material is at least one material selected from the group consisting of Si, Ge and Sn.

18. A probe as defined in claim 16, wherein said solid material is a carbon single crystal of which the crystal lattice sites are partially replaced by donor elements.

19. A probe as defined in any one of claims 12-18, wherein said probe is formed in pyramid shape.

20. A probe as defined in any one of claims 12-19, wherein the dimension of said probe is set to 10 nm or below.

21. A probe as defined in any one of claims 12-20, wherein said probe is made by cleaving a given bulky single crystal.
